# EUROPEAN PATENT APPLICATION

(11) **EP 2 924 444 A1**
(43) Date of publication of application: **30.09.2015**
(21) Application number: 14162292.8
(22) Date of filing: 28.03.2014
(51) Int. Cl.: G01P 5/08, G01L 9/00

(54) **Flow and pressure sensitive graphene sensor**

(71) Applicant: AIT Austrian Institute of Technology GmbH, 1220 Wien (AT); CEST Kompetenzzentrum für Elektrochemische Oberflächentechnologie GmbH, 2700 Wiener Neustadt (AT)
(72) Inventor: Rozman, Ciril, 1210 Wien (AT)
(74) Representative: Sonn & Partner Patentanwälte

(57) **Abstract**

The inventive provides a method of determining the flow speed or pressure of a fluid comprising providing a sensor comprising at least one graphene layer as semi-conductor material, contacting said sensor with said fluid, determining an electrical property of said graphene layer, such as an conductibility or an electric current, impedance or transistor gating of the graphene semi-conductor, and determining the flow speed or pressure as a result of said electrical property, wherein the graphene layer comprises reduced graphene oxide; and a flow and pressure sensitive graphene sensor flow cell for performing such a method.

## Description

### Background of the invention

Flow-meter devices measuring very slow liquid flow of fluids are only found in very high price ranges. Previous flow-meter devices usually determine flow-speed and/or mass transportation of high speed flows with flow-speed of at least 500 µl/min utilizing sensor geometries that require bulk amounts of sample liquid. The lowest measuring range of instruments on the market is achieved by the technology of thermal mass flow meters, which measure down to 100 µl/min but are much more costly in production.

A voltage flow sensor has been published by Newaz et al. (Nano Lett., 2012, 12 (6), p.2931-2935). Described is a chemical vapour deposited (CVD) graphene FET, that is used to determine the flow speed of ionic solutions. It has a detection limit for flow speeds at 4 mm/s.

Basic effects of pressure on graphene and applications based on graphene-surface force interactions are described by Proctor et al. (Phys. Rev. B, 2009, 80, p.073408).

CN 102338809 A describes a graphene based airflow measurement device. Graphene was deployed by the CVD method.

US2013/270511 A1 relates to a pressure sensor with a suspended graphene membrane spanned over a cavity.

WO2010/074918 A1 describes a method of producing graphene oxide membranes.

There remains the goal to measure flow seeds and fluid pressure, especially in microfluidics devices with little flow volume, with high sensitivity (i.e. at low flow rates). An improvement over prior art devices could also be achieved by providing such a sensor at low costs.

### Summary of the invention

These goals are achieved by the present invention, which provides in a first aspect a method of determining the flow speed or pressure of a fluid comprising providing a sensor comprising at least one graphene layer as semi-conductor material, contacting said sensor with said fluid, determining an electrical property of said graphene layer, such as a conductibility or an electric current, impedance or transistor gating of the graphene semi-conductor, and determining the flow speed or pressure as a result of said electrical property.

Preferably, the sensor comprises a field-effect transistor comprising a source, a gate and a drain, wherein the gate comprises as semiconductor the at least one graphene layer.

In a further aspect, the invention provides a flow cell comprising a fluid cell interior with a fluid inlet and a fluid outlet, comprising a fluid flow or pressure sensor in said fluid cell interior, wherein said sensor comprises a sensor composed of a field-effect transistor comprising a source, a gate and a drain, wherein the gate comprises as semiconductor at least one graphene layer.

The inventive method, flow cell or sensor is characterized by graphene layer comprising reduced graphene oxide and/or comprising graphene with an electron mobility of between 10000 to 100000 cm²/(V·s), preferably of 20000 to 80000 cm²/(V·s), even more preferred of 25000 to 60000 cm²/(V·s).

Surprisingly, it was discovered that graphene produced by the graphene oxide reduction method has substantially improved properties as a flow and pressure sensor. Graphene produced by this method may have different properties than other graphenes, such as produced by the CVD method.

Properties of the graphene layer used according to the invention may be any one of the following, which, in addition or alternatively, are properties to define the inventive graphene layer:
A) The graphene in the graphene layer may have an electron mobility of between 10000 to 100000 cm²/(V·s), preferably of 20000 to 80000 cm²/(V·s), even more preferred of 25000 to 60000 cm²/(V·s);
B) the graphene in the graphene layer may comprise residual graphene oxide or carbonyl moieties, such as in the range of 0.01 ppm to 1% oxygen (w/w), preferably of 0.1 ppm to 0.1% oxygen (w/w);
C) the graphene layer may be composed of graphene flakes (having 1 C atom thickness), which flakes may optionally have residual oxide or carbonyl moieties, such as in the range of 0.01 ppm to 1% oxygen (w/w), wherein the graphene layer comprises - according to its planar area - 10%-80% coverage by a single flake, 1%-50% coverage by at least 2 flakes (i.e. having flake overlaps), 1% to 40% of the area being not covered by a graphene flake;
or combinations thereof, such as A) and B), or A) and C).

The invention further provides methods of manufacturing said flow cell, sensor or graphene layer and uses in analytical methods.

### Detailed description of the invention

The following detailed description and preferred embodiments apply to all aspects of the invention as described in the summary of the invention and can be combined with each other without restriction, except where explicitly indicated. E.g. the inventive graphene layer, sensor devices and flow cells can be used in the inventive methods. Descriptions of methods of detection can be read to require the sensor, graphene layer or flow cell of the invention to be suitable for such methods. Used elements in methods of manufacture can be read on the provided products to have such elements. Especially preferred embodiments and aspects are defined in the claims.

The present invention provides a graphene based sensor suitable for flow speed and pressure measurements. The graphene layer has one of the above mentioned features A) to C) or was produced by the wet chemical graphene production method, which is based on a reduction of graphene oxide. Surprisingly, this graphene type has improved properties during flow speed and pressure measurements. This invention enables the fabrication of the first transportable flow-meter device able to determine flow speeds below 4 mm/s at low production costs.

For the analysis of flow speed preferably graphene field effect transistors are used. These devices are e.g. fabricated on graphene-coated silicon wafers via gold application. The interplay of the liquid with graphene in the semiconductor-channel determines variations in conductivity and hence enables a real-time read out for different applications, among them flow-speed measurement. The graphene sensor can measure and distinguish very slow flows down to 50 µm/s or even lower. Several possible application areas could benefit from a price efficient and accurate measuring device for liquid flows, e.g. in medicine, bio-sensing, lab equipment....

The invention improves on the detection limit of the sensor described by Newaz et al. (supra), which is at 4 mm/s, by at least a factor of 80. Additionally the chemical vapour deposition of graphene by Newaz et al. is more costly and requires bulky equipment, while wet-chemically synthesized graphene sensors can be produced at very low cost with minimum equipment. Thus there are two advantages provided by the invention: The detectable flow speed for microfluidics is much lower and the costs for the manufacture of a sensor could be greatly reduced.

Reduced graphene oxide graphene can be produced by e.g. reducing a graphene oxide. Graphene oxide is well known in the art and can be obtained by the methods described in WO2010/074918 A1 or Larisika et al., Materials Chemistry and Physics 2012 Volume 136, Issues 2-3: 304-30, e.g. by oxidizing graphite flakes (which may have several C atoms thickness). Graphene oxide production methods usually yield graphene oxide flakes, which are small sheets of graphene oxide having a thickness of one carbon atom. Graphene oxide flakes in the range of 100 µm² to 5 mm² are usually obtained. Oxidizing can be accomplished by exposing a graphite to sulfuric acid, nitric acid, potassium chlorate, potassium permanganate, potassium persulfate, hydrogen peroxide, phosphorus pentoxide, sodium chloride oxide, or other oxidizers, singly or in combination. The oxidation is suitably performed with care, as certain oxidizers are hazardous and should be handled with caution.

The chemical reduction of graphene oxide can be performed with a reduction agent, such as hydrazine or hydrogen (Larisika et al, supra). For the reduction reaction, the graphene oxide may be suspended in solution and the resulting graphene is then transferred to a solid surface that will form the sensor. Alternatively and preferred, the graphene oxide may be placed on a solid substrate and is then reduced to graphene so that the graphene is produced on the solid substrate. Attachment to a surface can be simple attraction of the graphene or graphene oxide to a surface or by use of an adhesive as described further herein and in the examples. Especially preferred, a vapour assisted hydrazine reduction method is used to produce the reduced graphene oxide graphene. Thus, the inventive sensor may comprise a graphene layer obtainable by a reduction of graphene oxide, that is preferably obtainable by a vapour assisted hydrazine or hydrogen reduction, especially preferred when performed on a solid substrate.

Preferably the graphene layer comprises graphene flakes of about 200 µm² or more, and/or comprises graphene sheets with an average size of between 100 µm² to 2000 µm², preferably 150 µm² to 1000 µm². In a FET, it is especially preferred when at least one of the flakes is connected to both, the source and drain electrodes. This can be ensured by selecting the above mentioned flake sizes. Flakes can be even as large as 3 mm², however larger flakes are less preferred as the oxidation or reduction reaction may not be hampered.

The inventive graphene layer may be defined by either feature A), B), C) mentioned in the summary section or be defined by the process of manufacture, or any combination thereof.

According to A) the graphene in the graphene layer may have an electron mobility in the range of 10000 cm²/(V·s) to 100000 cm²/(V·s), preferably of 20000 cm²/(V·s) to 80000 cm²/(V·s) or more, preferably the mobility is between 25000 cm²/(V·s) to 60000 cm²/(V·s) or between 30000 cm²/(V·s) to 50000 cm²/(V·s), it may be about 40000 cm²/(V·s) or more. Common electron mobilities for other graphenes are in the range of 10000 cm²/(V·s). The increased electron mobility might be a reason for the improved flow speed sensibility. These mobilities are at room temperature.

According to B) the graphene in the graphene layer may comprise residual graphene oxide or carbonyl moieties, such as in the range of 0.01 ppm to 1% oxygen (w/w), preferably of 0.1 ppm to 0.1% oxygen (w/w), or of 1 ppm to 0.05% oxygen (w/w), or any ranges in between these values. The residual oxygen or carbonyl, which may be present due to the manufacturing process, is a further indication of the inventive graphene, which has the improved sensing capabilities in the inventive methods. Such oxygen or carbonyl moieties are preferably at the edge of a 2D graphene flake. Carbon atoms at the edge of graphene sheets have special chemical reactivity.

According to C) the graphene layer may be composed of graphene flakes (having 1 C atom thickness), which flakes may optionally have residual oxide or carbonyl moieties, such as in the range of 0.01 ppm to 1% oxygen (w/w), wherein the graphene layer comprises. According to its planar area, 10%-80% coverage by a single flake, 1%-50% coverage by at least 2 flakes (i.e. having flake overlaps), 1% to 40% of the area being not covered by a graphene flake, or any combination thereof.

In preferred embodiments of the invention, the graphene layer or the graphene flakes may be continuous sheets of graphene and/or non-porous.

A "graphene layer" as used herein refers to a graphene region, which may be composed of one or usually more graphene flakes, which acts as a sensing element. In a FET, it is the graphene occupied area between the source and gate electrodes. Other graphenes, which are placed outside the electrode range and which does not generate a detectable signal is not included in the term "graphene layer" of the inventive sensor.

"Reduced graphene oxide graphene" is used to refer to a graphene that is produced by reducing graphene oxide.

It is to be understood that this invention is not limited to the specific devices, methods, applications, conditions or parameters described and/or shown herein, and that the terminology used herein is for the purpose of describing particular embodiments by way of example only and is not intended to be limiting of the claimed invention. Also, as used in the specification including the appended claims, the singular forms "a", "an", and "the" include the plural, and reference to a particular numerical value includes at least that particular value, unless the context clearly dictates otherwise. The term "plurality", as used herein, means more than one. Similarly, when values are expressed as approximations, by use of the antecedent "about", it will be understood that the particular value forms another embodiment. All ranges are inclusive and combinable.

Preferably the electrical property of the graphene layer is modified by changing the flow speed or pressure of a fluid and said modification of the electrical property is determined.

An electrical property can be detected by a first sense electrode (e.g. source) and a second sense electrode (e.g. drain) in contact on opposing sides of the graphene layer. Electrodes are preferably insulated to prevent stray currents through the fluid and/or the solid support or substrate.

In preferred embodiments the graphene layer has a size of 5 to 60 µm in one dimension, especially preferred the dimension between the source and gate electrodes of a FET.

The graphene layer, be e.g. in a sensor, may be provided on a substrate, including dipolar substrates, insulator, semiconductors (e.g. Si or Ge) or conductors. Preferred are insulators for uses of the graphene as semi-conductor, such as in a transistor. An example substrate is SiO₂. Other uses may comprise the graphene on conductors, e.g. for impedance measurements, which may be modified by pressure to or fluid flow over the graphene layer. The SiO₂ may electrically isolate the graphene and weakly interacted with it, providing nearly charge-neutral graphene layers. The silicon beneath the SiO₂ could be used as a "back gate" electrode to vary the charge density in the graphene over a wide range.

The graphene layer is a suitable element for various detection methods. Fluid flow and pressure can cause a Coulomb drag and subsequently a change in an electrical property of the graphene. A preferred detection method is electrical detection, e.g. the detection of the electrical resistance, surface plasmon resonance, cyclic voltammetry, impedance or conductivity of a field effect transistor. In such a transistor, the graphene layer preferably is the gate material, wherein it acts as a superconductor between the source and drain electrode to which it may be directly (e.g. attached) or indirectly connected. Also possible is quartz crystal microbalance. All of these methods can be used in the inventive uses and methods for determining a ligand or generally any binding agent to the graphene layer, lipid bilayer or protein.

Thus, in a preferred embodiment of any aspect of the invention, the sensor is being a field-effect transistor comprising a source, a gate and a drain, wherein the gate comprises as semi-conductor the at least one graphene layer. Pressure and or fluid flow over said graphene layer may modify the gating activity of said gate.

Graphene is a suitable gate material for the inventive sensors. The large field effect in graphene enables large shifts in the Fermi level by applying a gate voltage, thus tuning the electronic properties for sensor applications.

The graphene gate may be under the influence of a gate electrode, which may be at a close distance to the graphene layer, such as behind a substrate layer (back gating) or in contact with a liquid, which is in contact with the graphene layer (liquid gating). The gate electrode may or may not be in direct contact with the graphene layer.

Also used or provided are means to permit monitoring of the conductivity of the graphene element, by monitoring, for example, the electrical resistance or conductivity between the associated source and drain electrodes when a potential is applied to the gate, influenced by the fluid flow or pressure. Electrical disturbances induced by the fluid flow or pressure to the surface of the graphene layer can be measured.

In use, the conductivity of the graphene layer may be measured by applying a potential to the gate electrode associated with that element and by measuring the electrical resistance or conductivity between the source and drain electrodes. The pair of source and drain electrodes are usually substantially nonconductive as a result of the absence of an applied potential to the gate. The graphene as gate on the FET may contact the source and drain electrodes. Preferably, the electrical property is electric resistance or conductivity between a source and drain electrode of a field effect transistor when a potential is applied to a gate electrode, wherein a potential or conductivity of the graphene layer is modified by said flow or pressure.

The gate electrode may be a back gate, e.g. as described in US 2013/0018599 A, or a liquid gate, e.g. as described in Misra et al., Applied Physics Letters 90, 052905 (2007). A non-leak Ag/AgCl reference electrode may be used as an electrolyte gate. Preferably no further reference electrode is used, i.e. only source, gate and drain electrodes are used (of which there may be more than one each, if more than one sensor is used or provided in the flow cell). In preferred embodiments of the invention, the graphene layer is in a flow cell and the only electrodes in the flow cell are in contact with the graphene layer, especially preferred wherein the graphene layer is part of a FET and said source and drain connected to a graphene layer are the only electrodes in the flow cell.

The graphene layer according to any aspect of the invention may comprise graphene flakes of about 500 µm² or more, and/or comprises graphene sheets with an average size of between 200 µm² to 2000 µm², preferably 300 µm² to 1500 µm². "Graphene flake" is used herein to represent single graphene molecules, which form an essentially flat sheet. Sheet formation of the graphene flake can be supported by placement on the substrate. Preferably the graphene layer comprises a thickness of 1, 2, 3, 4, 5, 6, 7, 8, 9 or 10 graphene flakes or sheets, i.e. molecular layers, preferably 1 to 3 graphene flakes or sheets.

The graphene layer, or the area covered by the graphene flakes, preferably covers 30% to 100%, preferably 50% to 95%, especially preferred 70% to 92%, even more preferred 80% to 90%, or the sensor area of the substrate. The sensor area of the substrate is the area that can generate a detectible signal when functionalized with the graphene sensor layer. In a FET sensor it is the area between the source and drain electrodes. In a FET, it is especially preferred that the distance between the source and drain electrodes is in the range of 1 µm to 100 µm, especially preferred 3 µm to 80 µm, even more preferred 8 µm to 60 µm, especially preferred 10 µm to 40 µm. It is further preferred that the breadth of the source and/or drain electrodes is larger than the distance of the source and drain electrodes, especially the breadth of the electrodes may be at least 100 µm, at least 150 µm, at least 200 µm, at least 300 µm, at least 500 µm, such as in the range of 120 µm to 2000 µm. Especially preferred, the distance between the drain and the source is between 5 to 60 µm.

Another aspect of the invention is a flow cell to be used in the inventive method. The graphene layer may be in a flow cell having a lateral dimension, perpendicular to the plane of the graphene layer, in the range of 100 µm to 8 mm, preferably of 300 µm to 5 mm, especially preferred of 500 µm to 4 mm, even more preferred of 1 mm to 3 mm. Also preferred, alternatively or in combination, graphene layer is in a flow cell having a width, in the plane of the graphene layer, in the range of 100 µm to 8 mm, preferably of 300 µm to 5 mm, especially preferred of 500 µm to 4 mm, even more preferred of 1 mm to 3 mm. Such dimensions have been proven to be particular beneficial for increasing sensitivity during flow and/or pressure measurements.

The inventive flow cell or methods are particularly suitable to detect low flow speeds and pressures. E.g. according to any aspect of the invention, a fluid with a flow speed in the range of 0 to 3000 µm/s, preferably of 0.1 µm/s to 2500 µm/s, even more preferred of 0.2 µm/s to 2000 µm/s, especially preferred of 0.3 µm/s to 1500 µm/s, is moved in contact with the graphene layer. Such ranges, in which the inventive method is used for fine speed determination, can be present or preselected by a previous speed or pressure determination or by adjusting or selecting a pumping system to a speed which is expected to lie in tone of these ranges.

It is also contemplated that the graphene layer is surface modified by an organic molecule, preferably a biomolecule, especially preferred a protein, polynucleic acid or carbohydrate, such as a polycarbohydrate. Modifications may modify the sensing properties for flow or pressure measurement. The biomolecules can be placed, but are preferably immobilized, onto the graphene layer by a linker molecule, preferably a linker molecule comprising a graphene binding moiety, such as an aromatic moiety, e.g. a pyrene group. The graphene binding moiety preferably binds to graphene by pi-pi electron stacking. Preferred biomolecule can be selected from vertebrate and non-vertebrate proteins, preferably insect proteins. In general, the biomolecule or protein, may be from a mammal, especially a rodent or domestic animal such as a dog, cat, cow or horse, reptile, amphibian, marsupial, fish or insect.

In the inventive method method, the fluid (that is moved or pressurized) is contacted with said sensor, especially the modified graphene layer, in sufficient time and under conditions to allow a change in an electrical property of graphene. This can be performed non-continuously, e.g. in batch, or continuously, e.g. in a flow-cell. Preferably the fluid is continuously transferred through a detection cell containing the inventive sensor at a flow rate of 10 µL/min to 2000 µL/min, preferably of 100 to 800 µL/min, more preferred of about 300 µL/min.

In special embodiments the sample is a fluid, especially a liquid, preferably an aqueous liquid.

Also provided is a flow cell comprising a fluid cell interior with a fluid inlet and a fluid outlet, comprising a fluid flow or pressure sensor in said fluid cell interior, wherein said sensor comprises a sensor composed of a field-effect transistor comprising a source, a gate and a drain, wherein the gate comprises as semiconductor at least one graphene layer, wherein said graphene layer characterized in that said graphene layer comprises reduced graphene oxide and/or graphene with an electron mobility of between 10000 to 100000 cm²/(V·s), preferably between 20000 to 80000 cm²/(V·s). Any of the above mentioned embodiments for methods or graphene layers etc. also are suitable for the inventive flow cell. The flow cell may comprise an inner chamber with an inlet and an outlet. It may also be tubular with inlet and outlet in the tube. Preferably, the flow cell has an interior width and or height each independently selected from a dimension in the range of 100 µm to 8 mm, preferably of 300 µm to 5 mm, especially preferred of 500 µm to 4 mm, even more preferred of 1 mm to 3 mm. Preferably the measured fluid is moved through an area of a size of 1000 µm² to 50 mm² during measurement. The flow cell may have a cross sectional area perpendicular to a cell wall at the location of the graphene layer. The area may in preferred embodiments be 10000 µm² to 20 mm² or 100000 µm² to 5 mm².

The inventive flow cell may be provided in a kit together with either or both of a) a fluid, especially a liquid, pump, and/or b) a computer readable memory device comprising a computer program product for performing the inventive method, e.g. by including computer instructions for converting electrical property (e.g. current) data into a flow speed or pressure information. Preferably the computer program also includes instructions for a calibration method. A computer readable memory device is e.g. a CD, DVD, BR, flash drive or hard disk.

Also provided is a method of manufacturing a flow cell according to the invention, comprising assembling a FET comprising source, a gate and a drain, wherein the gate comprises as semi-conductor at least one graphene layer, placing the FET into a flow cell interior and wherein the graphene layer is manufactured by reducing graphene oxide flakes.

Also provided is a method for the manufacture of a graphene layer according to the invention, e.g. to be used in the manufacture of the flow cell, comprising the step of providing a sheet of graphene on a substrate, optionally wherein said graphene is attached to said substrate with an adhesive, preferably an aminosilane such as APTES, applying a lipid linker, with a graphene adhesive functionality to said graphene layer. The substrate can be a non-conductor, a semiconductor or a conductor, preferably a non-conductor for later FET uses.

Also provided is a method of manufacture of a sensor according to the invention comprising providing the step of providing a sheet of graphene on a substrate, optionally wherein said graphene is attached to said substrate with an adhesive, preferably an aminosilane such as APTES, said substrate is a non-conductor, a semiconductor or a conductor, preferably a non-conductor for later FET uses.

A method of forming a semiconductor flow and/or pressure sensor device may also include the steps of forming an insulating layer on a semiconductor substrate, forming a first graphene layer on a surface of the insulating layer, forming a first sense electrode (e.g. source) and a second sense electrode (e.g. drain) on the insulating layer on opposing sides of, and in contact with, the first graphene membrane, and forming a sealing ring around outer sidewalls of the first and second sense electrodes and the first graphene layer.

The present invention is further illustrated by the following examples and figures, without being limited to these embodiments of the invention. Of course each single element of these further embodiments can be combined with each aspect of the invention as described above.

### Figures:

Fig. 1: measuring signal for low pump speeds. A: signal vs. time; B: log. regression of pump speed to detection signal
Fig. 2: measuring signal for higher pump speeds. A: signal vs. time; B: log. regression of pump speed to detection signal

### Examples:

### Example 1: Manufacture and set-up of flow and pressure sensor

All materials were purchased from Sigma Aldrich, unless otherwise stated.

Preparation of field effect transistor devices Silicon substrate with 300 nm silicon oxide layer was chosen as basal layer for the FETs. The SiO₂ substrates were cleaned with a standard RCA cleaning procedure. The substrates were then submerged in a 1-2% APTES solution in Ethanol for 1 h, APTES forming a self-assembled monolayer to increase the adsorption of graphene. After rinsing with ethanol, the substrates were heated to 120°C for two hours and afterwards cooled to room temperature. Graphene oxide sheets were prepared using a variation of the Hummers method derived for the application on FETs (Materials Chemistry and Physics, 2012, 136(2-3), p.304-308). The obtained graphene oxide was applied on Si-Wafer via Spin coating or drop casting of the top portion of the graphene-oxide solution. The devices were then treated in hermetically sealed glass petri dishes with Hydrazine at 70°C overnight to accomplish graphene-oxide reduction, forming the graphene structure consisting of sp²-hybridized bonds. Graphene flake distribution was preliminary checked with an optical microscope and chosen devices then characterized using SEM.

Electrical preparations Electrodes were applied consisting of gold (60-100 nm) with an adhesive layer of chrome (2-3 nm) using a standard evaporation process with a shadow mask. A chip holder was designed for this process, ensuring the central positioning of the electrodes as well as reducing electrode geometry glazing because of unwanted shadow offset during the evaporation process. Success of the used reduction technique via hydrazine was probed before (Materials Chemistry and Physics, 2012, 136(2-3), p.304-308), so resistance of the fabricated devices was adducted for check-up of graphene-oxide reduction quality using a Fluke Multimeter. To assure conductivity of the used electrolyte not being higher than the conductivity of used graphene layers, all devices displaying higher conductivity than an equivalent to ∼800 Ohm were dismissed, equivalent to the resistance of 170 mM PBS buffer at room temperature.

Characterization techniques Scanning electron microscopy (SEM) images were recorded. Optical microscopy images were taken with a microscope.

Measurement setup Electrical measurements (I_{D}T, I_{D}V_{G}) were conducted using a probe station "Keithley 4200". All measurements were performed using a custom made flow cell made of PMMA with fixed flow channel geometry (16 µl), ensuring a defined flow rate of 995 µL/min in all experiments. Furthermore electrode drillings for constant gate-electrode distance (2 mm) and a hollow with FET geometry for fixed positioning of the devices were incorporated to the flow cell.

### Example 2: Optional graphene surface modification

Phosphate buffered saline solutions with total ionic strength of 17 mM were used for all experiments, pH-values were adjusted using NaOH and KOH solutions. 1-pyrenebutanoic acid succinimidyl ester (PBSE) was used as linker and diluted to a 2.5 µM solution in tetrahydrofuran and applied on prepared FET device shortly before antibody incubation for 5 minutes. Anti-BSA stock solution was diluted in PBS at 1 µM concentration and incubated after linker immobilization for two hours on the devices. Bovine serum albumin used for experiments was also solved in 17 mM PBS buffer with pH 7.4 and further diluted to the desired concentration.

### Example 3: Flow and pressure measurement

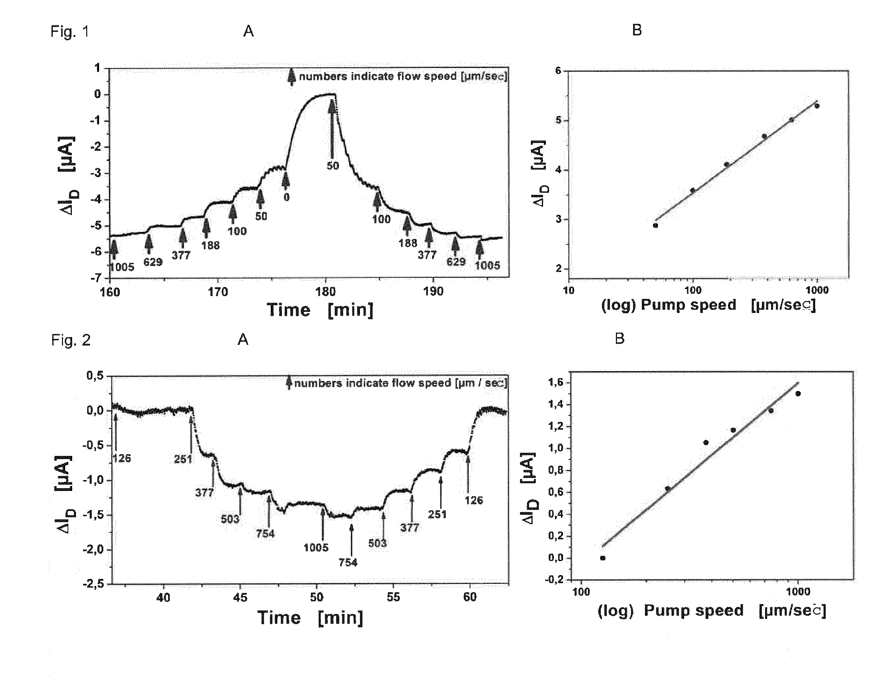

First measurements were conducted at constant Gate-Voltage using a Ismatec high Precision Multichannel Dispenser device for speed adjustment with step-by-step increasing of pump speed after a constant signal is detected for the previous speed step. Distilled Water was used as transport medium. (Fig. 1 and 2).

As shown in figures 1 and 2, after each flow speed change, in Fig. 1 first decreases until T=177 min, then increase, a rapid change in the current is observed, which equilibrates to a new current for the given flow-speed. The small spikes, e.g. observable in Fig. 1 between T=175 min and T=177 min, are due to pulsations in the peristaltic pump. In these experiments, the highest sensitivity was observed with flow speeds in the range of 0 µm/s to 200 µm/s.

The relation between signal-output (Drain-current) and flow speed was found to have exponential character. The Fit for this relation shows concordance between 96% and 99% when plotted on logarithmic scale. (Fig. 1 and 2).

## Claims

1. A method of determining the flow speed or pressure of a fluid comprising
providing a sensor comprising at least one graphene layer as semi-conductor material,
contacting said sensor with said fluid,
determining an electrical property of said graphene layer, such as a conductibility or an electric current, impedance or transistor gating of the graphene semi-conductor,
and determining the flow speed or pressure as a result of said electrical property,
**characterized in that** said graphene layer comprises reduced graphene oxide and/or graphene with an electron mobility of between 20000 to 100000 cm²/(V·s).

2. The method according to claim 1, wherein the graphene layer comprises graphene sheets of about 200 µm² or more, and/or comprises graphene sheets with an average size of between 100 µm² to 1000 µm², preferably 150 µm² to 500 µm².

3. The method according to claim 1 or 2, wherein said electrical property is modified by changing the flow speed or pressure of a fluid and said modification of the electrical property is determined.

4. The method according to any one of claims 1 to 3, wherein the graphene layer has a size of 5 to 60 µm.

5. The method according to any one of claims 1 to 4, wherein the sensor comprises a field-effect transistor comprising a source, a gate and a drain, wherein the gate comprises as semi-conductor the at least one graphene layer.

6. The method according to claim 5, wherein the distance between the drain and the source is between 5 to 60 µm.

7. The method according to claim 5 or 6, wherein said electrical property is electric resistance or conductivity between a source and drain electrode of a field effect transistor when a potential is applied to a gate electrode, wherein a potential or conductivity of the graphene layer is modified by said flow or pressure.

8. The method according to any one of claims 1 to 7, wherein said graphene layer is in a flow cell having a lateral dimension, perpendicular to the plane of the graphene layer, in the range of 100 µm to 8 mm, preferably of 300 µm to 5 mm, especially preferred of 500 µm to 4 mm, even more preferred of 1 mm to 3 mm.

9. The method according to any one of claims 1 to 8, wherein said graphene layer is in a flow cell having a width, in the plane of the graphene layer, in the range of 100 µm to 8 mm, preferably of 300 µm to 5 mm, especially preferred of 500 µm to 4 mm, even more preferred of 1 mm to 3 mm.

10. The method according to any one of claims 1 to 9, wherein said graphene layer is in a flow cell and the only electrodes in the flow cell are in contact with the graphene layer, especially preferred wherein the graphene layer is part of a FET according to claim 5 and said source and drain connected to a graphene layer are the only electrodes in the flow cell.

11. The method according to any one of claims 1 to 10, wherein a fluid with a flow speed in the range of 0 to 3000 µm/s, preferably of 0.1 µm/s to 2500 µm/s, even more preferred of 0.2 µm/s to 2000 µm/s, especially preferred of 0.3 µm/s to 1500 µm/s, is moved in contact with the graphene layer.

12. The method according to any one of claims 1 to 11, wherein said graphene layer is surface modified by an organic molecule, preferably a biomolecule, especially preferred a protein, polynucleic acid or carbohydrate, such as a polycarbohydrate.

13. A flow cell comprising a fluid cell interior with a fluid inlet and a fluid outlet, comprising a fluid flow or pressure sensor in said fluid cell interior, wherein said sensor comprises a sensor composed of a field-effect transistor comprising a source, a gate and a drain, wherein the gate comprises as semi-conductor at least one graphene layer, wherein said graphene layer **characterized in that** said graphene layer comprises reduced graphene oxide and/or graphene with an electron mobility of between 20000 to 100000 cm²/(V·s).

14. The flow cell of claim 13, wherein the graphene layer or flow cell is defined as in any one of claims 2, 4, 6 to 10 and/or 12.

15. Method of manufacturing a flow cell according to claim 13 or 14, comprising assembling a FET comprising source, a gate and a drain, wherein the gate comprises as semiconductor at least one graphene layer, placing the FET into a flow cell interior and wherein the graphene layer is manufactured by reducing graphene oxide flakes.
